(19) Europäisches Patentamt
European Patent Office
Office européen des brevets

(11) EP 1 103 629 B1

(12) EUROPÄISCHE PATENTSCHRIFT

(45) Veröffentlichungstag und Bekanntmachung des Hinweises auf die Patenterteilung:
**08.01.2003 Patentblatt 2003/02**

(51) Int Cl.[7]: **C23C 14/24**

(21) Anmeldenummer: **00123302.2**

(22) Anmeldetag: **26.10.2000**

(54) **Keramischer Verdampfer**

Ceramic evaporator

Evaporateur en céramique

(84) Benannte Vertragsstaaten:
**DE FR GB NL**

(30) Priorität: **25.11.1999 DE 19956811**

(43) Veröffentlichungstag der Anmeldung:
**30.05.2001 Patentblatt 2001/22**

(73) Patentinhaber: **Wacker-Chemie GmbH**
**81737 München (DE)**

(72) Erfinder:
- **Seifert, Martin**
  **87471 Durach (DE)**
- **Urbat, Hans-Werner**
  **87439 Kempten (DE)**

(74) Vertreter: **Potten, Holger et al**
**Wacker-Chemie GmbH**
**Zentralabteilung Patente,**
**Marken und Lizenzen**
**Hanns-Seidel-Platz 4**
**81737 München (DE)**

(56) Entgegenhaltungen:
**DE-A- 19 735 814** **DE-C- 880 529**
**GB-A- 1 137 560** **US-A- 6 085 025**

- **PATENT ABSTRACTS OF JAPAN vol. 012, no. 479 (C-552), 14. Dezember 1988 (1988-12-14) & JP 63 192860 A (HITACHI LTD), 10. August 1988 (1988-08-10)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 103 629 B1

## Beschreibung

Die Erfindung betrifft einen keramischen Flash-TV-Verdampfer.

Flash-TV-Verdampfer werden zum Bedampfen von Schwarz/Weiß- bzw. Farbbildröhren mit Aluminium verwendet, um eine elektrisch leitende Schicht von einigen 100 nm in den Bildröhren zu erzeugen. Diese Schicht stellt die Elektrode zur Beschleunigung der Elektronen in der fertigen Bildröhre dar.

Fig. 1 A / B zeigen einen herkömmlichen Flash TV-Verdampfer in seiner Befestigung. In der Bedampfungsanlage ist der Flash-TV-Verdampfer (1) auf beiden Seiten mit Hilfe von zwei Schrauben (2) zwischen zwei Stahlplatten (8) geklemmt. Die Stahlplatten (8) sind über Kupferkabel (9) mit einer Stromquelle verbunden. Zur besseren Kontaktierung liegt in der Regel zwischen Stahlplatte (8) und Flash-TV-Verdampfer (1) eine Graphitfolie (5).

Die Maße eines üblichen Flash-TV-Verdampfers betragen 4 * 6 * 110 mm. Er besitzt eine im Querschnitt des Flash-TV-Verdampfers rechteckige Kavität (6; Fig. 1C). Die Kavität hat in der Regel eine Dimension von 2 * 4 * 40 oder 60 mm. Die Breite der seitlichen Einspannung beträgt an beiden Enden etwa 15 mm. Die aufzuheizende Länge des Flash-TV-Verdampfers beträgt normalerweise 80 mm.

Das Bedampfen der Bildröhren erfolgt diskontinuierlich. In die Kavität des Flash-TV-Verdampfers, wird ein Stück Aluminium (< 100 mg), in der Regel ein zylinderförmiger Al-Körper, ein sogenanntes Pellet, gelegt. Über dem Flash-TV-Verdampfer wird der zu bedampfende Bildröhrendeckel positioniert. Anschließend wird der Raum unterhalb des Bildröhrendeckels evakuiert, so daß der Flash-TV-Verdampfer mit Einspannung in diesem Vakuum liegt ($10^{-5}$ mbar).

Durch direkten Stromdurchgang wird der Flash-TV-Verdampfer in zwei Spannungsschritten(Vorheizen|Verdampfen Fig.7, Fig.8) erhitzt und dabei verdampft er das in seiner Kavität liegende Aluminium. Die Zeit, die für diesen Vorgang benötigt wird, liegt im Bereich von 40 sek bis zu 2 min. Die Stromdichten, die dabei auftreten, erreichen kurzzeitig Werte bis zu $10^3$ A/ $cm^2$.

Diese hohe Strom- und damit Temperaturbelastung ist es, die die Standzeit, d. h. die Anzahl der Aufheizzyklen des Flash-TV-Verdampfers begrenzt.

Üblicherweise reißt nach 500 - 900 Aufheizzyklen der Flash-TV-Verdampfer im Bereich der Kavität. Er zerbricht und muß ausgetauscht werden.

DE 19735814 offenbart einen Flash-TV-Verdampfer mit verbesserter Standzeit, verbessertem Verdampfungsverhalten und einem verbesserten Benetzungsverhalten, der dennoch in den üblichen Verdampferanlagen verwendet werden kann. Dieser Flash-TV-Verdampfer unterscheidet sich von den bis dahin genutzten Flash-TV-Verdampfern durch seine dreieckförmige Kavität (6). Er ist im Querschnitt in Fig. 1 (D) dargestellt.

Aufgabe der vorliegenden Erfindung ist es einen Flash-TV-Verdampfer zum Bedampfen von Bildröhren mit Aluminium mit weiteren verbesserten Eigenschaften zur Verfügung zu stellen.

Die Aufgabe wird gelöst durch einen keramischen Flash-TV-Verdampfer, enthaltend eine Kavität, deren Breite sich im Querschnitt durch den Verdampfer von der Verdampferoberkante zur Verdampferunterkante verjüngt, und bei dem der Übergang der Seitenwände des Verdampfers zur Verdampferunterseite im Querschnitt zumindest über einen Teil der Längsachse des Verdampfers elliptisch verrundet ist, dadurch gekennzeichnet, daß die elliptische Verrundung der Unterseite des Flash-TV-Verdampfers an der Seitenwand nach etwa 1 bis 3 mm gemessen von der Oberkante des Flash-TV-Verdampfers beginnt.

Der erfindungsgemäße Flash-TV-Verdampfer besitzt vorzugsweise eine Kavität die im Querschnitt durch den Flash-TV-Verdampfer dreiecksförmig ist. Die beiden Seitenflächen der dreiecksförmigen Kavität können dabei gerade (Fig. 2) oder konvex (Fig. 3) oder konkav (Fig. 4) gekrümmt sein. Der tiefste Punkt der Kavität kann als Radius ausgebildet sein (Fig. 5).

Im Extremfall führt dies bei einer konvexen Krümmung der Seitenflächen zur Halbkreisform der Kavität.

Im Extremfall führt dies bei einer konkaven Krümmung der Seitenflächen zu einem schmalen linienförmigen Vertiefung in Längsrichtung des Flash-TV-Verdampfers als Kavität.

Vorzugsweise ist die Kavität an der Verdampferoberfläche 2 mm bis 5 mm breit.

Vorzugsweise liegt die tiefste Stelle der Kavität mindestens 1 mm und maximal 3 mm unter der Verdampferoberkante.

Vorzugsweise beträgt die Länge der Kavität zwischen 30 mm und 80 mm.

Im folgenden umfaßt der Begriff "Unterseite" des Flash-TV-Verdampfers auch den Übergang des Seitenbereichs des Flash-TV-Verdampfers zur Unterseite.

Bevorzugt besitzt der erfindungsgemäße Verdampfer im Querschnitt an der Unterseite im Bereich der Kavität die Form einer geteilten Ellipse, während er im Bereich der Verdampferenden im Querschnitt eine rechteckig geformte Unterseite besitzt.

Die Form der geteilten Ellipse ist vorzugsweise dergestalt, als ob die Teilung der Ellipse entlang ihrer Hauptachse erfolgt wäre. Besonders bevorzugt beginnt die elliptische Verrundung der Unterseite des Flash-TV-Verdampfers an der Seitenwand im Bereich der Kavität nicht über die ganze Breite der Kavität im gleichen Abstand von der Oberkante des Flash-TV-Verdampfers.

Besonders bevorzugt beginnt die elliptische Verrundung der Unterseite des Flash-TV-Verdampfers an der Seitenwand im Bereich der Enden der Kavität in geringerem Abstand von der Oberkante des Flash-TV-Verdampfers als im Bereich der Mitte der Kavität. Vorzugsweise bleibt dabei die Form der elliptischen Verrundung unverändert.

Besonders bevorzugt ist der Übergang des Beginns der elliptischen Verrundung vom Ende der Kavität zur Mitte der Kavität kontinuierlich.

Die beschriebene bevorzugte Verrundung bewirkt, daß sich die Querschnittsfläche des Flash-TV-Verdampfers ohne Berücksichtigung des durch die Kavität bedingten Flächenverlustes entlang seiner Längsachse ändert.

In der besonders bevorzugten Ausführungsform besitzt der Flash-TV-Verdampfer zusätzlich eine Veränderung der Querschnittsfläche entlang seiner Längsachse derart, daß die Querschnittsfläche ohne Berücksichtigung des durch die Kavität bedingten Flächenverlustes im Bereich der Enden der Kavität geringer ist als in der Mitte der Kavität. Dies ist schematisch in Fig. 6 (A) bis 6 (E) dargestellt.

Beim erfindungsgemäßen Flash-TV-Verdampfer kommen die Flashes mit den Aluminiumpellets sehr gleichmäßig, d. h. immer zur selben Zeit nach Beginn des Aufheizzykluses. Zudem ist die Flashzeit (die Zeit vom Beginn des Schmelzens des Pellets bis zum vollständigen Verdampfen des Pellets) kürzer als bei bekannten Flash-TV-Verdampfern. Das Aluminium fließt schneller in der Kavität auseinander was ebenfalls von Vorteil ist.

Insbesondere besitzt ein Flash-TV-Verdampfer, bei dem die Querschnittsfläche im Bereich der Enden der Kavität geringer ist als in der Mitte der Kavität, eine sehr hohe Standzeit, da durch diese Formgebung die thermische Belastung des Flash-TV-Verdampfers in der Mitte der Kavität minimiert ist und eine Zersetzung (Veränderung) des Materials erst später als bei bekannten Flash-TV-Verdampfern stattfindet.

Durch die erfindungsgemäß bewirkte Querschnittvergrößerung des Flash-TV-Verdampfers im Bereich der Mitte der Kavität verringern sich die maximalen Stromdichten und es ist eine höhere Anzahl von Aufheizzyklen möglich.

Gleichzeitig werden durch die erfindungsgemäße Form auch die aus DE 19735814 bekannten Vorteile der V-förmigen Kavität genutzt. So wird durch die V-Kavität das zylinderförmige Al-Pellet genau in der Längsachse der Kavität des Flash-TV-Verdampfer positioniert, was zu einer homogeneren Ausbreitung der Al-Dampfwolke unabhängig von der Zahl der Aufheizzyklen führt. Weiter wirkt die untere Kante der Kavität als Kapillare, was zu einer besseren Benetzung des Flash-TV-Verdampfers durch das A1 führt.

Der erfindungsgemäße Flash-TV-Verdampfer läßt sich aus den für Verdampfer üblichen keramischen Pulvern, die $TiB_2$, BN und ggf. AlN enthalten, herstellen.

Er läßt sich in üblichen Verdampferanlagen betreiben, ohne daß Veränderungen an diesen Anlagen vorgenommen werden müssen.

Fig. 1 (A) bis (D) zeigt einen Standard Flash-TV-Verdampfer in einer Einspannung in Aufsicht (A), Seitenansicht (B) und rechteckigem Kavitätsquerschnitt (C) bzw. dreieckigem Kavitätsquerschnitt (D).

Fig. 2 zeigt einen erfindungsgemäßen Flash-TV-Verdampfer (1) dessen Kavität (6) im Querschnitt durch den Flash-TV-Verdampfer eine Dreiecksform mit geraden Wänden besitzt und dessen Unterseite im Bereich der Kavität elliptisch gerundet ist (7). Die elliptische Verrundung der Unterseite des Flash-TV-Verdampfers beginnt nicht direkt an der Oberkante des Verdampfers sondern an der Seitenwand nach etwa 2 mm gemessen von der Oberkante des Flash-TV-Verdampfers.

Fig. 3 zeigt einen erfindungsgemäßen Flash-TV-Verdampfer (1), dessen Kavität(6) im Querschnitt durch den Flash-TV-Verdampfer eine Dreiecksform mit konvex gekrümmten Wänden (3a) besitzt, und dessen Unterseite im Bereich der Kavität elliptisch gerundet ist, wie für Fig. 2 beschrieben.

Fig. 4 zeigt einen erfindungsgemäßen Flash-TV-Verdampfer (1), dessen Kavität (6) im Querschnitt durch den Flash-TV-Verdampfer eine Dreiecksform mit konkav gekrümmten Wänden (3b) besitzt, und dessen Unterseite im Bereich der Kavität elliptisch gerundet ist, wie für Fig. 2 beschrieben.

Fig. 5 zeigt einen erfindungsgemäßen Flash-TV-Verdampfer (1), dessen tiefster Punkt der Kavität (6) in Form eines Radius (4) ausgeführt ist, und dessen Unterseite im Bereich der Kavität elliptisch gerundet ist, wie für Fig. 2 beschrieben.

Fig. 6 (A) bis (E) zeigen in einer Draufsicht, einer Seitenansicht und drei Querschnitten eine besonders bevorzugte Ausführungsform eines erfindungsgemäßen Flash-TV-Verdampfers, bei dem der Querschnitt im Bereich (10) der Enden der Kavität (6) verringert ist.

Fig. 7 zeigt 4.Flashes des erfindungsgemäßen TV-Verdampfers (Flash 16 - 19) aus dem Beispiel. Die obere Kurve zeigt den Spannungsverlauf, die untere Kurve zeigt den Stromverlauf. (Abstand der durchgehenden Spalten-Teilstriche 10 sek, der kurzen Spalten-Teilstriche am oberen/unteren Rand 2,5 sek; Abstand der Zeilen-Teilstriche 20 Ampere.)

Fig. 8 zeigt 4 Flashes des Standard-TV-Verdampfers (V2) (Flash 16 - 19) aus dem Beispiel. Die obere Kurve zeigt den Spannungsverlauf, die untere Kurve zeigt den Stromverlauf. (Abstand der durchgehenden Spalten-Teilstriche 10 sek, der kurzen Spalten-Teilstriche am oberen/unteren Rand 2,5 sek; Abstand der Zeilen-Teilstriche 20 Ampere.)

Fig. 9 (A) und (B) zeigen einen vergrößerten Ausschnitt des Stromverlaufs aus Fig. 7 und Fig. 8. Ab Beginn "Verdampfen" sind zum Vergleich untereinander je die 4 Flashes aus Fig. 7 /Fig. 8 wiedergegeben. (Abstand der durchgehenden Spalten-Teilstriche 10 sek, der kurzen Spalten-Teilstriche in der Mitte bzw. am unteren Rand 2,5 sek; Abstand der Zeilen-Teilstriche 20 Ampere.)

Das folgende Beispiel dient der weiteren Erläuterung der Erfindung:

**Beispiel:**

Ein erfindungsgemäßer elliptischer Flash-TV Verdampfer (V1) und ein üblicher Flash-TV Verdampfer (V2) aus einem für Flash-TV Verdampfer üblichen keramischen Material wurden in einer Verdampfereinspannung betrieben.

**Erfindungsgemäßer Verdampfer (V1):** Maße über alles: 4 * 6 * 110 mm; Im Querschnitt des Flash-TV-Verdampfers dreieckige Kavität mit geraden Wänden (größte Tiefe * Breite * Länge: 2 * 4 * 60 mm). Elliptische Verdampferunterseite über die gesamte Länge der Kavität; Beginn der elliptischen Verrundung im Bereich der Verdampferenden (25 mm von den Enden des Verdampfers) minimal 1,5 mm unterhalb der Verdampferoberkante; in der Mitte der Kavität 2,0 mm unterhalb der Verdampferoberkante; Übergang siehe Fig. 6. Verjüngte elliptische Verdampferunterseite an beiden Enden der Kavität über eine Länge von 15 mm. Verjüngung 0,5 mm. Die Breite der seitlichen Einspannung beträgt an beiden Enden etwa 15 mm. Die aufzuheizende Länge des Flash-TV-Verdampfers beträgt 80 mm. **Standard TV- Verdampfer (Vergleichsverdamfer; V2):** Maße über alles wie (V1). Im Querschnitt des Flash-TV-Verdampfers dreieckige Kavität (2 * 4 * 60 mm). Die Breite der seitlichen Einspannung entspricht V1. Die aufzuheizende Länge des Flash-TV-Verdampfers entspricht V1. Das Material entspricht V1.

Versuchsbedingungen:

(A1-Pelletmasse = 85 mg)/ Vakuum: $<1*10^{-4}$ mbar

| | |
|---|---|
| V1: Vorheizen: 4,0V/25sek | Verdampfen:9,0V/25sek |
| V2: Vorheizen: 4,5V/25sek | Verdampfen:9,5V/25sek |

Da mindestens 10 Flashes durchgeführt werden müssen, um die TV-Verdampfer ,einzufahren, sind in den Figuren 7 und 8 jeweils die Flashes 16 - 19 wiedergegeben. Die obere Kurve zeigt den Spannungsverlauf, die untere Kurve den Stromverlauf.

Fig. 7 zeigt die 4 Flashes (abgekürzt als F116 , F117, F118 und F119) des erfindungsgemäßen TV-Verdampfers (V1). Fig. 8 zeigt die 4 Flashes (abgekürzt als F16 , F17, F18 und F19) des Standard-TV-Verdampfers (V2). Zur besseren Erkennbarkeit gibt Fig. 9 (A), (B) einen vergrößerten Ausschnitt aus Fig. 7 und Fig. 8 wieder.

Der Flash zeigt sich in den Figuren als hoher Strompeak. Der Strompeak wird durch das Aufschmelzen und Auseinanderfließen des Pellets erzeugt(ansteigende Flanke). Dann verdampft das A1 (abfallende Flanke) bis der TV-Verdampfer wieder "trocken" ist.

Die Flashzeit des erfindungsgemäßen elliptischen TV-Verdampfers (V1) beträgt etwa 5 s, die des Standard-TV-Verdampfers (V2) etwa 7 s.

Die abfallende Flanke ist bei V2 länger als bei V1. Das bedeutet, daß das A1 bei V2 länger in der Kavität liegt als bei V1.

Benetzung und Verdampfen findet bei V1 bei niedrigeren Spannungen statt als bei V2. (V1: 4,0V / 9,0V; V2: 4,5V / 9,5V). Das bedeutet, daß die Stromdichte in V1 und damit auch die Belastung des Materials geringer ist als in V2.

Weiter kommen die Flashes bei V1 etwa 3 s eher als bei V2. Sie kommen zudem bei V1 sehr viel gleichmäßiger als bei V2. Das bedeutet, daß bei V1 die Benetzung besser ist, und die Temperatur im Bereich der Kavität schneller ansteigt.

Auch die höhere Gleichmäßigkeit der Flashes bei V1 führt zu einer Schonung des Materials von V1. Da die Flashes so früh kommen, könnte in einer Bedampfungsanlage sogar mit noch geringeren Spannungen und damit mit noch geringeren Stromdichten gearbeitet werden, was wiederum die Materialbelastung weiter vermindert und die Standzeit des Verdampfers weiter erhöht.

**Patentansprüche**

1. Keramischer Flash-TV-Verdampfer zum Bedampfen von Bildröhren mit Aluminium, enthaltend eine Kavität, deren Breite sich im Querschnitt durch den Verdampfer von der Verdampferoberkante zur Verdampferunterkante verjüngt, und bei dem der Übergang der Seitenwände des Verdampfers zur Verdampferunterseite im Querschnitt zumindest über einen Teil der Längsachse des Verdampfers elliptisch verrundet ist, **dadurch gekennzeichnet, daß** die elliptische Verrundung der Unterseite des Flash-TV-Verdampfers an der Seitenwand nach etwa 1 bis 3 mm gemessen von der Oberkante des Flash-TV-Verdampfers beginnt.

2. Keramischer Flash-TV-Verdampfer gemäß Anspruch 1, **dadurch gekennzeichnet, daß** er eine Kavität besitzt, die im Querschnitt durch den Flash-TV-Verdampfer dreiecksförmig ist.

3. Keramischer Flash-TV-Verdampfer gemäß Anspruch 2, **dadurch gekennzeichnet, daß** die beiden Seitenflächen der dreiecksförmigen Kavität gerade oder konvex oder konkav gekrümmt sind.

4. Keramischer Flash-TV-Verdampfer gemäß Anspruch 2 oder 3, **dadurch gekennzeichnet, daß** der tiefste Punkt der Kavität als Radius ausgebildet ist.

5. Keramischer Flash-TV-Verdampfer gemäß einem der Ansprüche 1 bis 4, **dadurch gekennzeichnet, daß** er im Querschnitt an der Unterseite im Bereich der Kavität die Form einer geteilten Ellipse besitzt und im Bereich der Verdampferenden eine im Querschnitt rechteckig geformte Unterseite besitzt.

6. Keramischer Flash-TV-Verdampfer gemäß einem der Ansprüche 1 bis 5, **dadurch gekennzeichnet, daß** die elliptische Verrundung der Unterseite des Flash-TV-Verdampfers an der Seitenwand im Bereich der Enden der Kavität nicht über die ganze Breite der Kavität im gleichen Abstand von der Oberkante des Flash-TV-Verdampfers beginnt.

7. Keramischer Flash-TV-Verdampfer gemäß einem der Ansprüche 1 bis 6, **dadurch gekennzeichnet, daß** die elliptische Verrundung der Unterseite des Flash-TV-Verdampfers an der Seitenwand im Bereich der Enden der Kavität in geringerem Abstand von der Oberkante des Flash-TV-Verdampfers als im Bereich der Mitte der Kavität beginnt.

8. Keramischer Flash-TV-Verdampfer gemäß Anspruch 7, **dadurch gekennzeichnet, daß** die Form der elliptischen Verrundung unverändert bleibt und der Übergang des Beginns der elliptischen Verrundung vom Ende der Kavität zur Mitte der Kavität kontinuierlich verläuft.

## Claims

1. Ceramic flash TV evaporator for the evaporation coating of picture tubes with aluminium, containing a cavity whose width tapers in cross section through the evaporator from the upper edge of the evaporator to the lower edge of the evaporator, and in which evaporator the transition of the side walls of the evaporator to the underside of the evaporator is elliptically rounded in cross section at least over part of the longitudinal axis of the evaporator, **characterized in that** the elliptic rounding of the underside of the flash TV evaporator begins on the side wall after about 1 to 3 mm measured from the upper edge of the flash TV evaporator.

2. Ceramic flash TV evaporator according to Claim 1, **characterized in that** it has a cavity which is triangular in cross section through the flash TV evaporator.

3. Ceramic flash TV evaporator according to Claim 2, **characterized in that** the two side faces of the triangular cavity are straight or curved convexly or concavely.

4. Ceramic flash TV evaporator according to Claim 2 or 3, **characterized in that** the lowest point of the cavity is designed as a radius.

5. Ceramic flash TV evaporator according to one of Claims 1 to 4, **characterized in that** it has the form of a divided ellipse in cross section on the underside in the region of the cavity, and has an underside of rectangular shape in cross section in the region of the ends of the evaporator.

6. Ceramic flash TV evaporator according to one of Claims 1 to 5, **characterized in that** the elliptic rounding of the underside of the flash TV evaporator begins on the side wall in the region of the ends of the cavity not over the entire width of the cavity but the same distance from the upper edge of the flash TV evaporator.

7. Ceramic flash TV evaporator according to one of Claims 1 to 6, **characterized in that** the elliptic rounding of the underside of the flash TV evaporator begins on the side wall in the region of the ends of the cavity at a smaller distance from the upper edge of the flash TV evaporator than in the region of the centre of the cavity.

8. Ceramic flash TV evaporator according to Claim 7, **characterized in that** the form of the elliptic rounding remains unchanged and the transition of the beginning of the elliptic rounding from the end of the cavity to the centre of the cavity runs continuously.

## Revendications

1. Evaporateur Flash-TV en céramique pour métalliser sous vide des tubes cathodiques avec de l'aluminium, comprenant une cavité dont la largeur diminue en section transversale à travers l'évaporateur depuis le côté supérieur de l'évaporateur jusqu'au côté inférieur de l'évaporateur, et dans lequel la transition des parois latérales de l'évaporateur vers la face inférieure de l'évaporateur est en section transversale arrondie en ellipse au moins sur une partie de l'axe longitudinal de l'évaporateur, **caractérisé en ce que** l'arrondi elliptique de la face inférieure de l'évaporateur Flash-TV sur la paroi latérale commence après environ 1 à 3 mm du côté supérieur de l'évaporateur Flash-TV.

2. Evaporateur Flash-TV en céramique suivant la revendication 1, **caractérisé en ce qu'**il possède une cavité, qui a une section transversale de forme triangulaire à travers l'évaporateur Flash-TV.

3. Evaporateur Flash-TV en céramique suivant la revendication 2, **caractérisé en ce que** les deux faces latérales de la cavité de forme triangulaire sont droites ou à courbure convexe ou concave.

4. Evaporateur Flash-TV en céramique suivant la revendication 2 ou 3, **caractérisé en ce que** le point le plus profond de la cavité a la forme d'un rayon.

5. Evaporateur Flash-TV en céramique suivant l'une quelconque des revendications 1 à 4, **caractérisé en ce qu'**il possède en section transversale, sur la face inférieure dans la zone de la cavité, la forme d'une ellipse divisée et **en ce qu'**il possède dans la zone des extrémités de l'évaporateur une face inférieure avec une section transversale de forme rectangulaire.

6. Evaporateur Flash-TV en céramique suivant l'une quelconque des revendications 1 à 5, **caractérisé en ce que** l'arrondi elliptique de la face inférieure de l'évaporateur Flash-TV sur la face latérale dans la zone des extrémités de la cavité ne commence pas à la même distance du côté supérieur de l'évaporateur Flash-TV sur toute la largeur de la cavité.

7. Evaporateur Flash-TV en céramique suivant l'une quelconque des revendications 1 à 6, **caractérisé en ce que** l'arrondi elliptique de la face inférieure de l'évaporateur Flash-TV sur la face latérale dans la zone des extrémités de la cavité commence à une plus petite distance du côté supérieur de l'évaporateur Flash-TV que dans la zone du milieu de la cavité.

8. Evaporateur Flash-TV en céramique suivant la revendication 7, **caractérisé en ce que** la forme de l'arrondi elliptique reste inchangée et la transition du commencement de l'arrondi elliptique s'étend en continu depuis l'extrémité de la cavité jusqu'au milieu de la cavité.

Fig. 1A

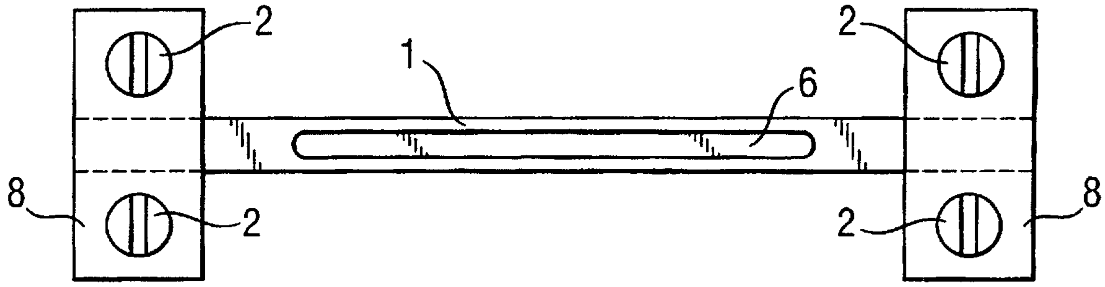


Fig. 1B

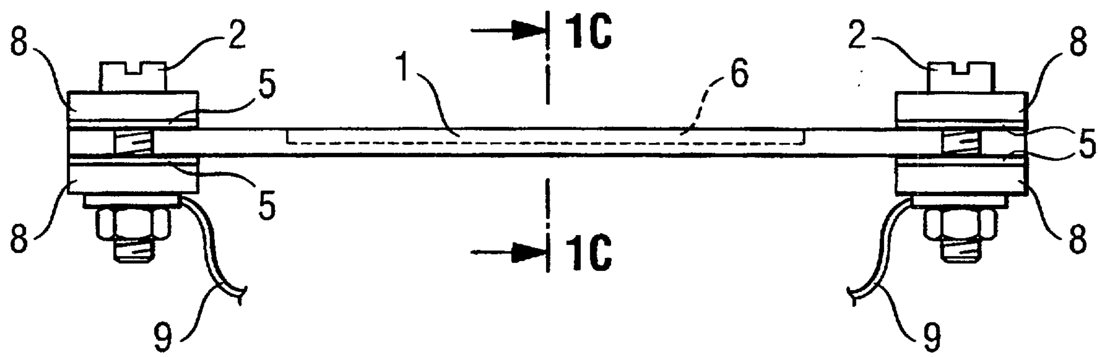


Fig. 1C
(1C - 1C)

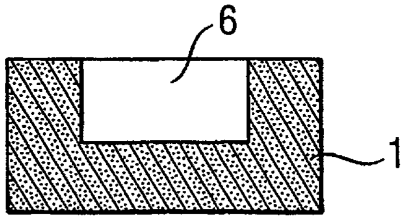


Fig. 1D

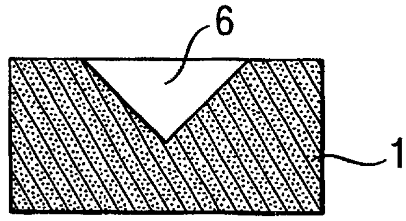

Fig. 2

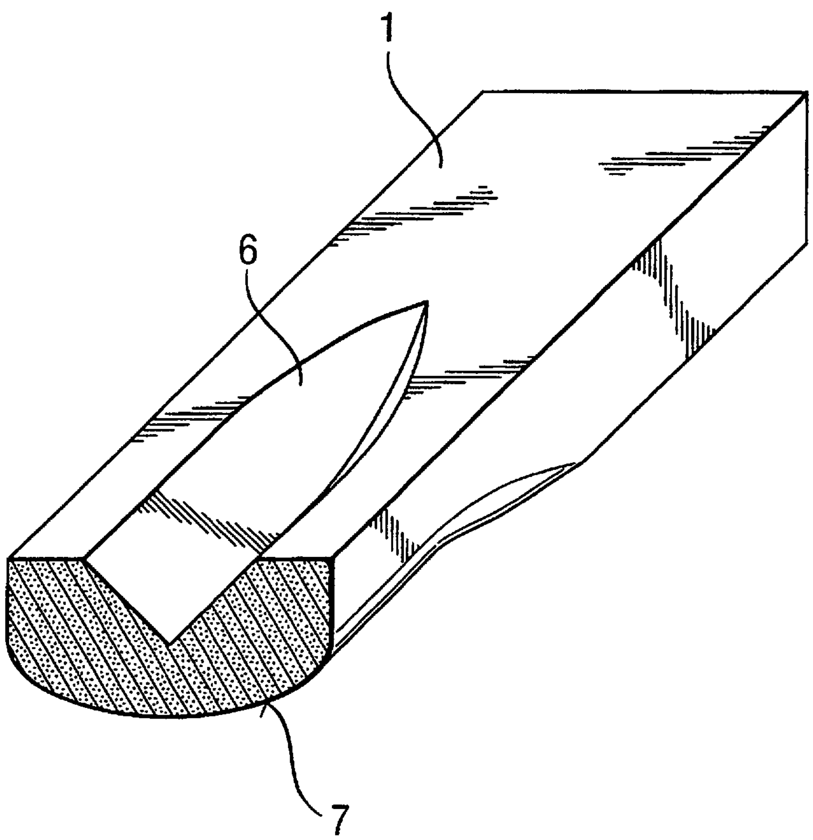

Fig. 3

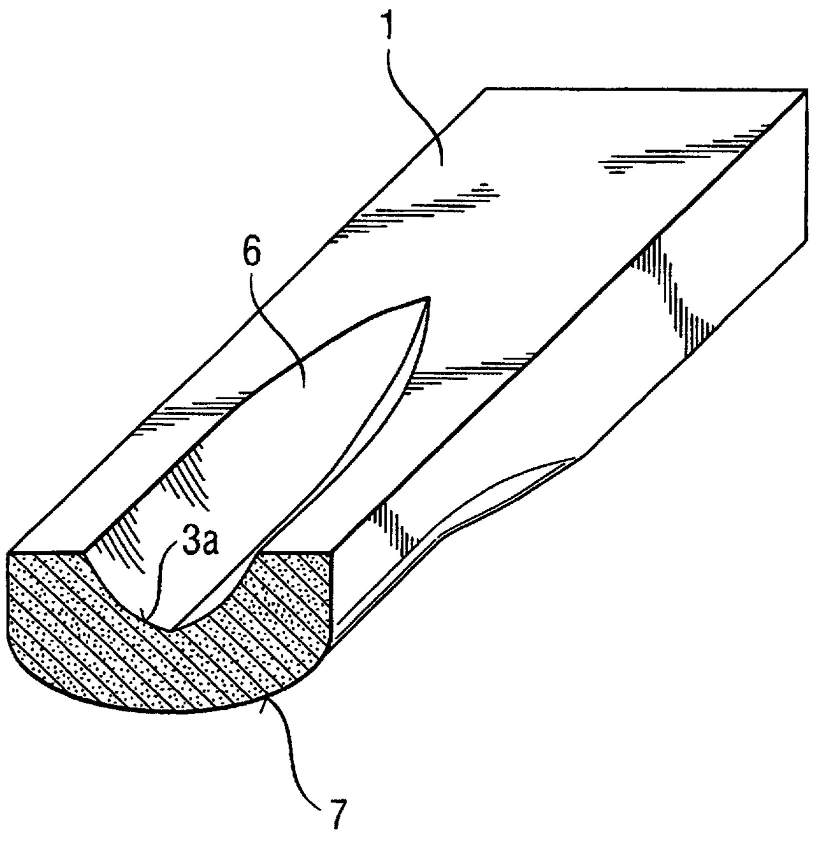

Fig. 4

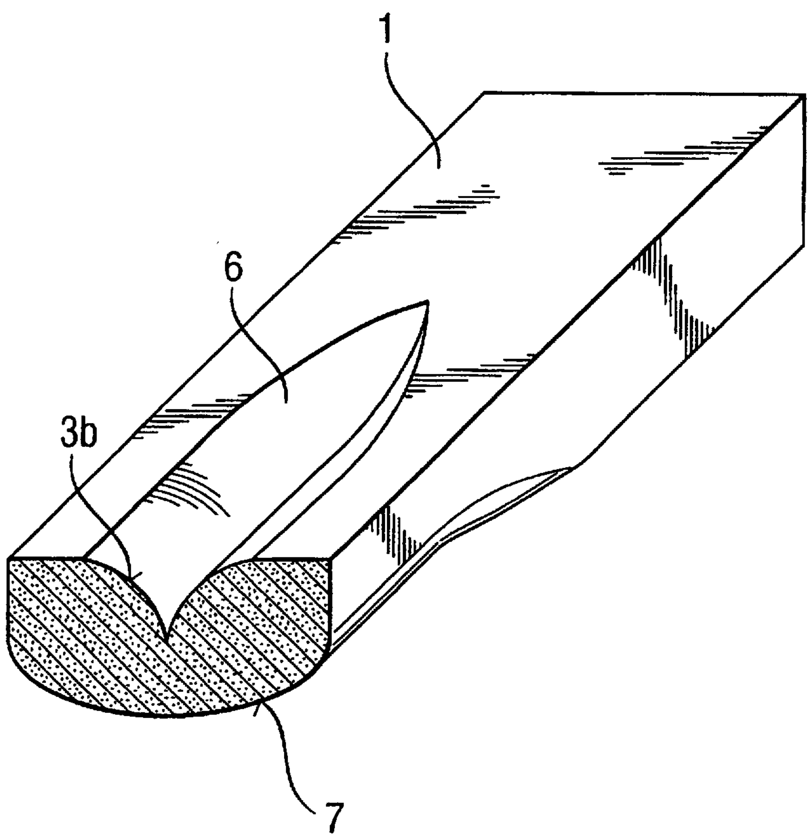

Fig. 5

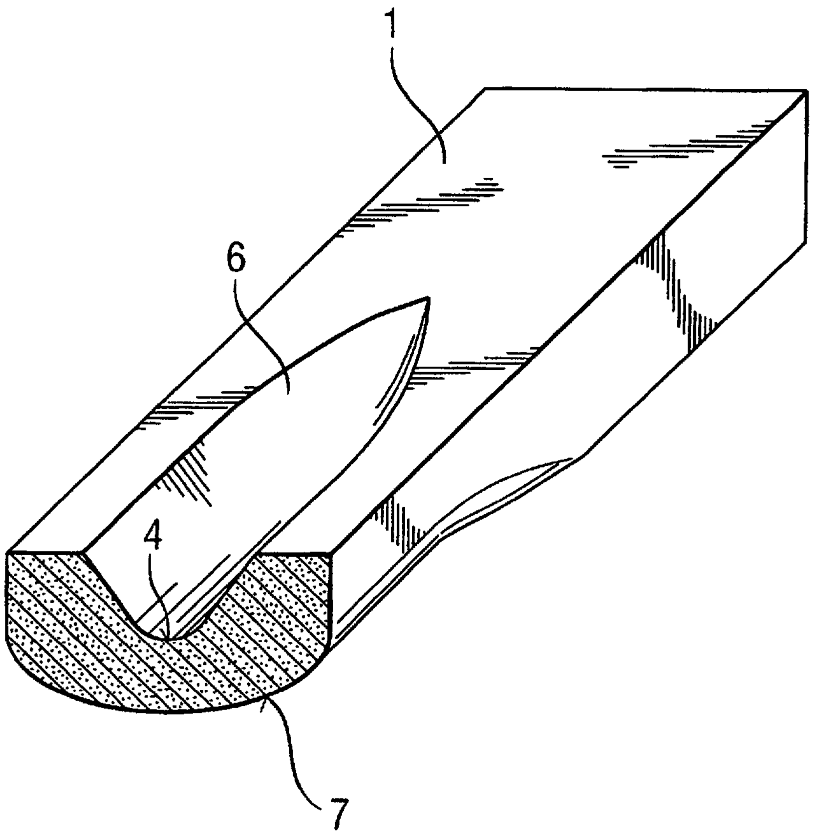

Fig. 6A

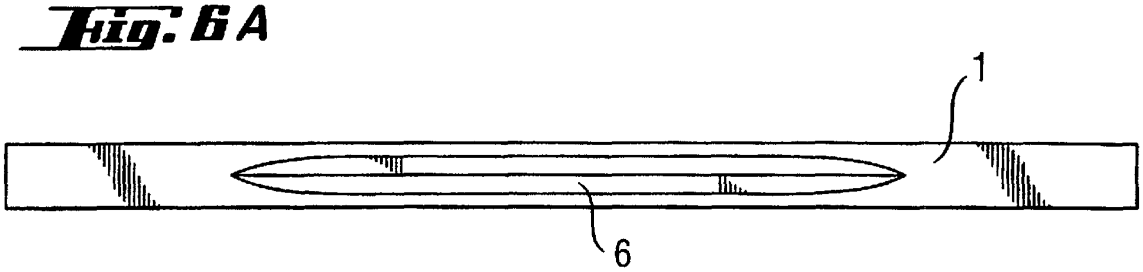


Fig. 6B

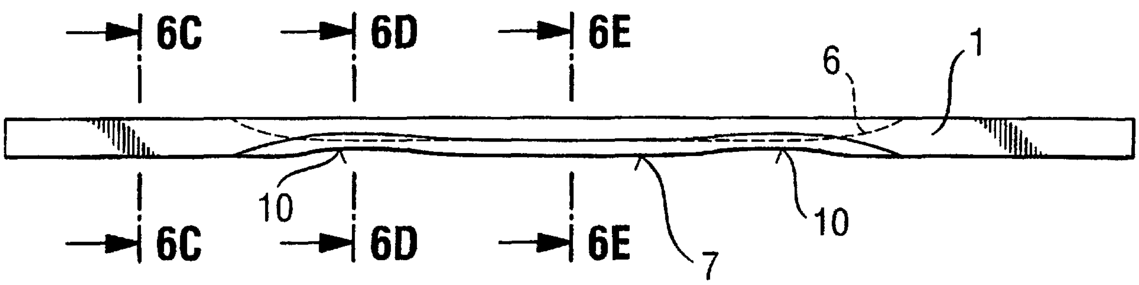


Fig. 6C
(6C - 6C)

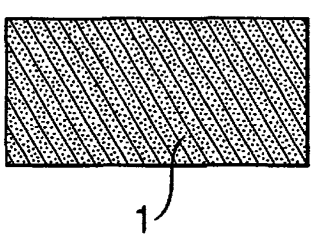


Fig. 6D
(6D - 6D)

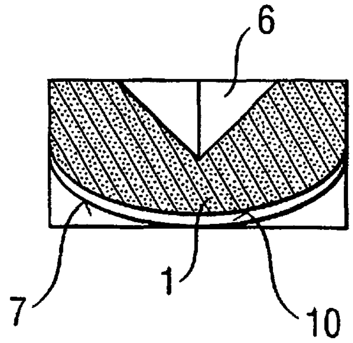


Fig. 6E
(6E - 6E)

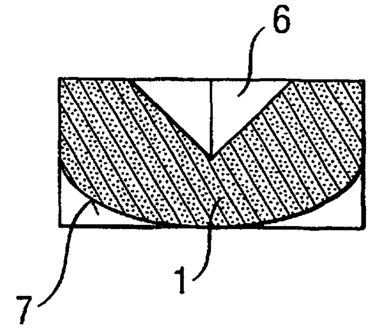

Fig. 2

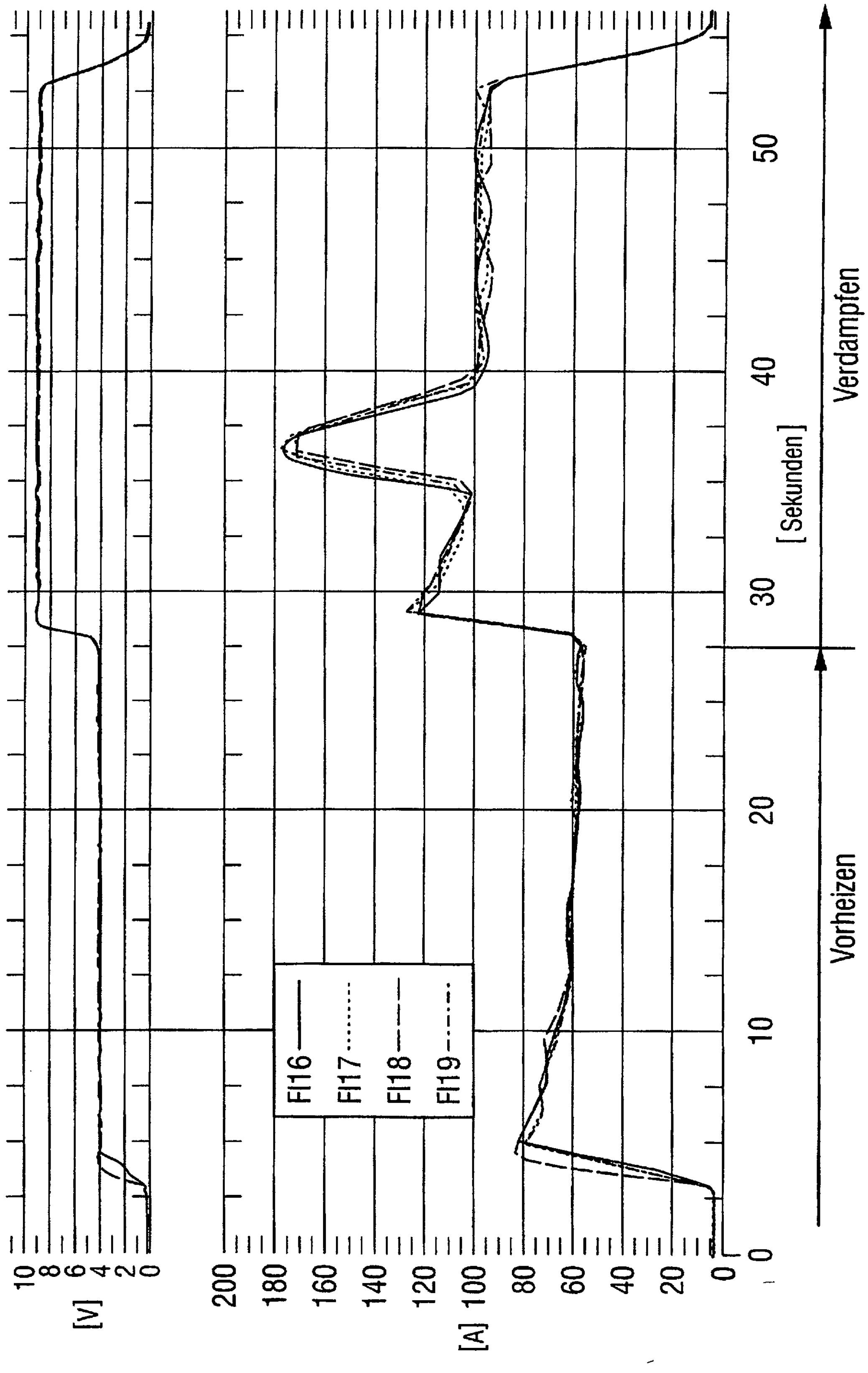
[V]
10 8 6 4 2 0
[A]
200 180 160 140 120 100 80 60 40 20 0
FI16
FI17
FI18
FI19
0 10 20 30 40 50
[Sekunden]
Vorheizen
Verdampfen

Fig. 8

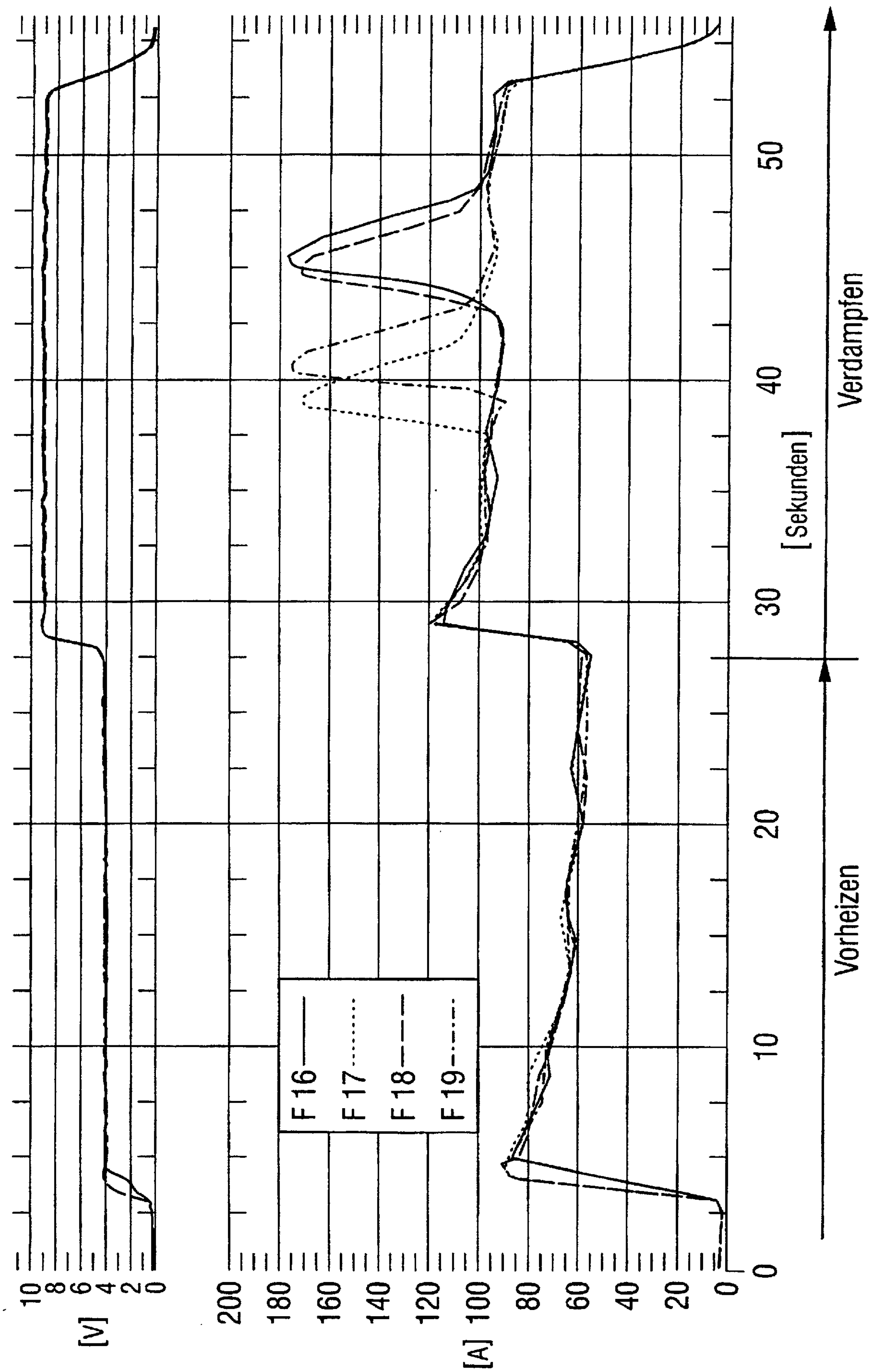
[V]
10
8
6
4
2
0
[A]
200
180
160
140
120
100
80
60
40
20
0
F 16
F 17
F 18
F 19
0
10
20
30
40
50
[Sekunden]
Vorheizen
Verdampfen

Fig. 9A

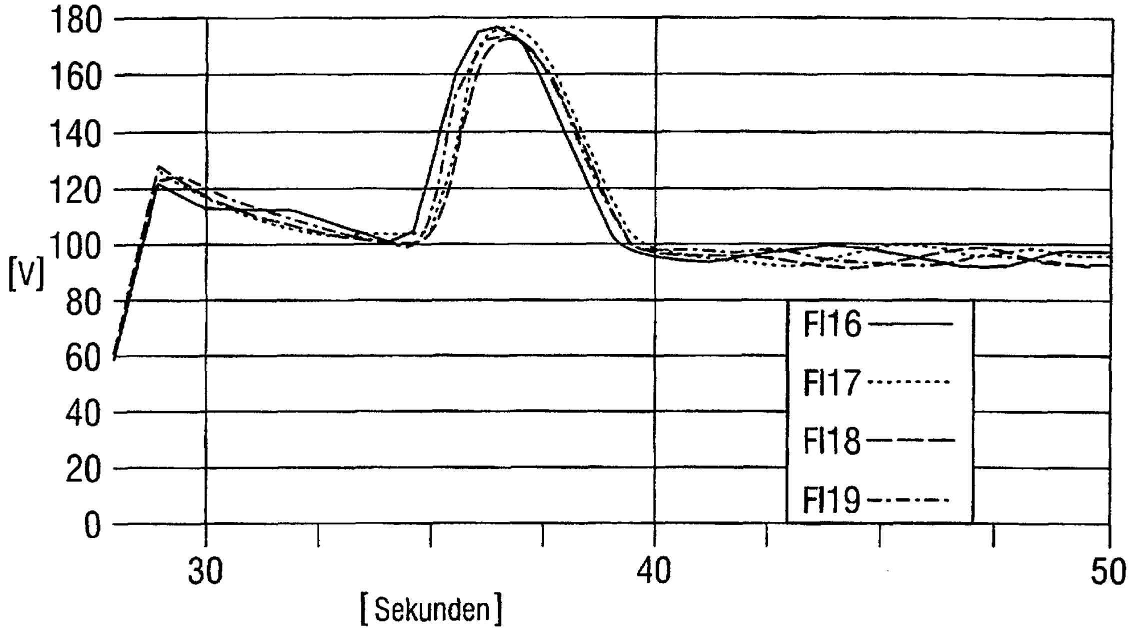
180
160
140
120
100
80
60
40
20
0
[V]
30
40
50
[Sekunden]
Fl16
Fl17
Fl18
Fl19

Fig. 9B

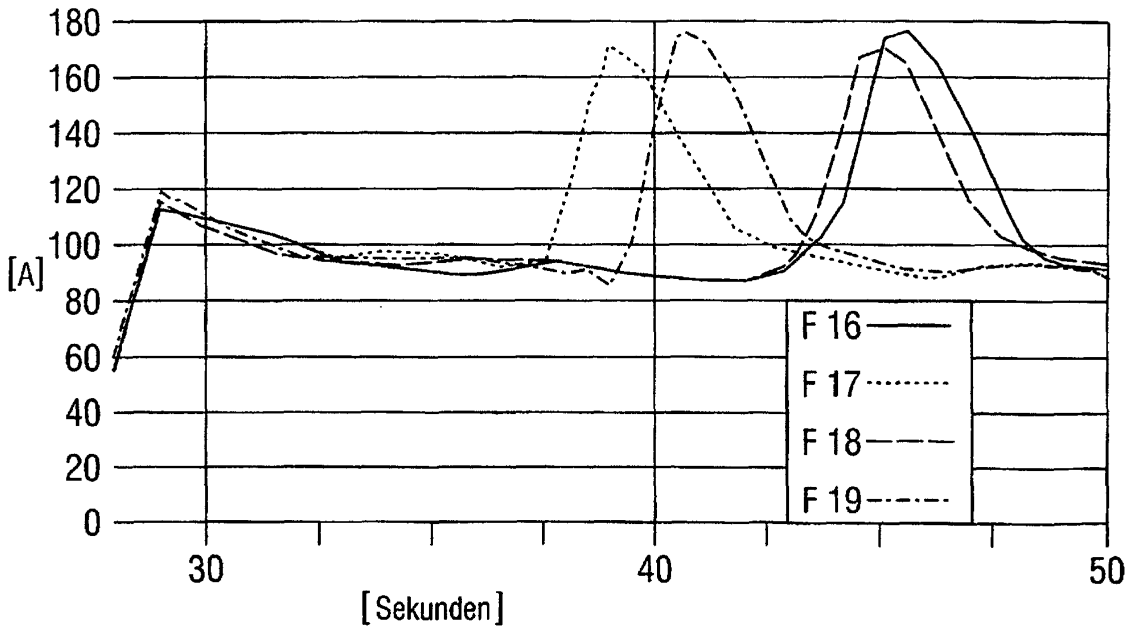
180
160
140
120
100
80
60
40
20
0
[A]
30
40
50
[Sekunden]
F 16
F 17
F 18
F 19